# EUROPEAN PATENT APPLICATION

(11) **EP 1 760 525 A1**
(43) Date of publication of application: **07.03.2007**
(21) Application number: 06254291.5
(22) Date of filing: 18.08.2006
(51) Int. Cl.: G03F 1/00, G03F 7/20, G03F 9/00

(54) **Device manufacturing method, mask and device**

(30) Priority: 30.08.2005 US 214058
(71) Applicant: ASML Netherlands B.V., 5504 DR Veldhoven (NL)
(72) Inventor: Megens, Henricus Johannes Lambertus, 5581 HD Waalre (NL)
(74) Representative: Leeming, John Gerard

(57) **Abstract**

A method for use in manufacturing CCD or CMOS image sensors in which a substrate covered in a layer of colored radiation sensitive material has a patterned beam of radiation projected onto it. The patterned beam of radiation includes a pattern for forming device features in areas of a product die and a pattern for use in forming features of an alignment mark in other areas. This avoids the difficulty of aligning on alignment marks which are below a colored resist.

## Description

### Field

The present invention relates to a method for manufacturing a device, a mask for use in the method and a device manufactured by the method.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

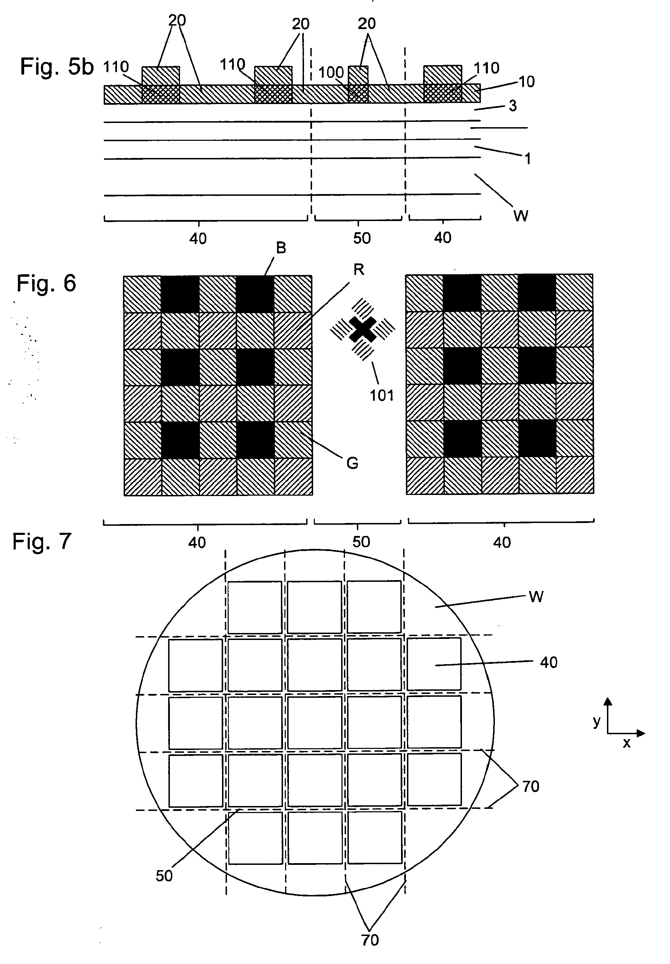

In the manufacture of CCD and CMOS image sensors color filters are applied to the surface of the image sensors such that each detection pixel is covered by a color filter. Most applications use red, green and blue filters and some applications also use cyan, magenta, green and yellow color filters. Thus, one of the last phases of manufacture of a CCD or CMOS image sensor comprises applying to the substrate a layer of a colored radiation sensitive material (resist) and irradiating that radiation sensitive material (the color resist is typically a negative resist) so that during subsequent development of the resist the required filters of that particular color remain in place over the desired pixels. Generally a green or red resist is used first, followed by the other of the green or red resist and finally a blue resist to build up a grid of pixels such as that shown in Figure 6 in which blue (B), red (R) and green (G) filters are arranged in regular pattern over pixels.

### SUMMARY

It is desirable to provide a method in which the accuracy of alignment of the substrate relative to the mask can be improved during the final manufacturing steps of creating colored filters on CCD and CMOS image sensors.

According to an aspect of the invention, there is provided a device manufacturing method comprising:
- projecting a patterned beam of radiation onto a substrate covered in a first layer of colored radiation sensitive material, the pattern of said patterned beam including a pattern for use in forming device features in areas of product die and a pattern for use in forming features of an alignment mark in other areas.

According to an aspect of the invention, there is provided a mask for use in the method comprising patterning structures for endowing a projection beam of radiation with a pattern useful in forming color filters on a die or dies on a substrate and patterning structures for endowing said projection beam of radiation with a pattern useful in forming an alignment mark in areas outside said dies.

According to an aspect of the invention, there is provided a device manufactured according to the method comprising features of said alignment mark.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 depicts, in cross-section, a manufacturing step in which a first color radiation sensitive material is being irradiated;
- Figure 3 illustrates the substrate of Figure 2 following irradiation;
- Figure 4 illustrates the substrate of Figure 3 following development;
- Figure 5a illustrates the substrate of Figure 4 following application of a second layer of color radiation sensitive material; and
- Figure 5b illustrates the substrate of Figure 4 following an alternative application of a second layer of color radiation sensitive material;
- Figure 6 illustrates, in plan, a CCD or CMOS image sensor; and
- Figure 7 shows in plan, a complete substrate W with a plurality of dies and scribe lines illustrated.

### DETAILED DESCRIPTION

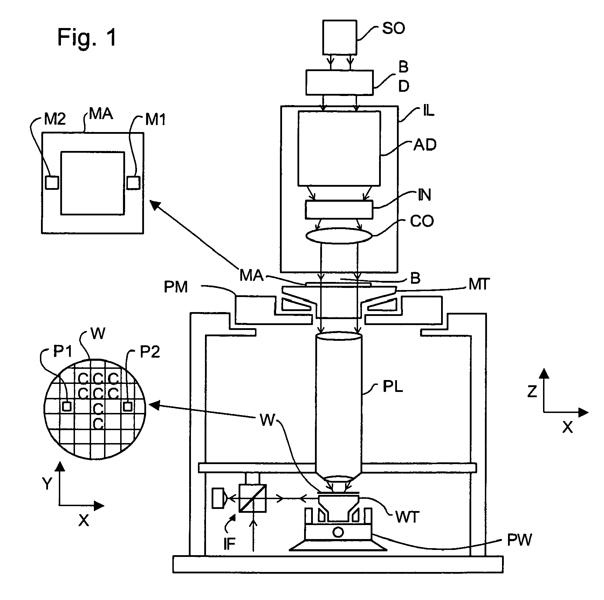

Figure 1 schematically depicts a lithographic apparatus according to one embodiment of the invention. The apparatus comprises:
- an illumination system (illuminator) IL configured to condition a radiation beam B (e.g. UV radiation or EUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

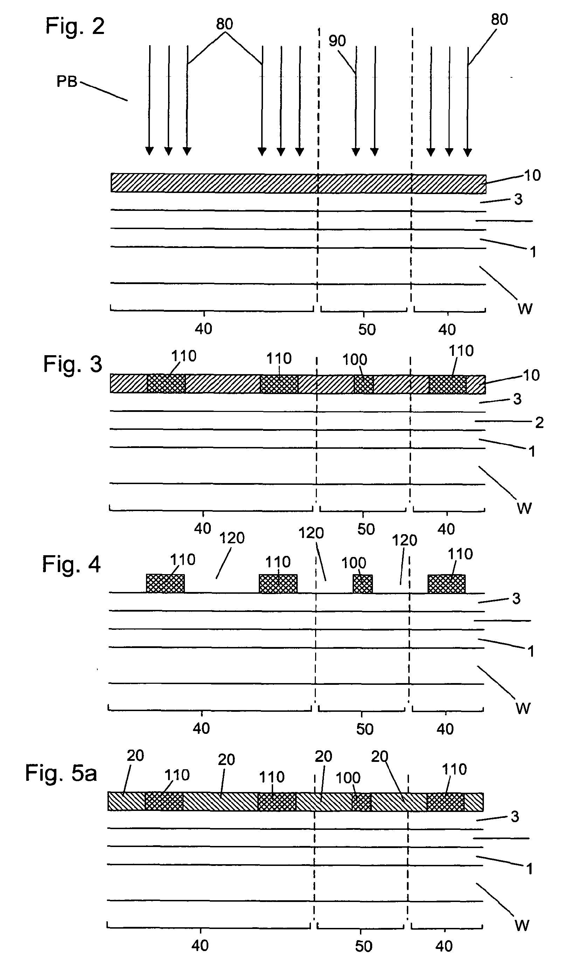

Figure 2 illustrates a substrate W on which a CCD or CMOS image sensor is being manufactured. A metal oxide layer 1 has been deposited on the substrate as has a first passivation layer 2 which is typically an oxide. On top of that a second passivation layer 3 has been deposited which is typically SiON. The substrate has been processed normally (a device pattern, not illustrated, has already been created between the substrate and the metal oxide layer 1) and alignment has occurred on an alignment mark deposited on or etched in the substrate W or in subsequent layers of the device in the normal way.

A colored radiation sensitive material 10 is then applied in a first layer. Typically this first layer of color radiation sensitive material is chosen to be red or green and the substrate W can be aligned on an original alignment mark because alignment sensors can penetrate through the green or red colored first radiation sensitive material 10.

However, with the current alignment sensors used in lithographic apparatus, it can be difficult to accurately align the substrate through a blue (or cyan) color resist because the state of the art alignment sensors use a red laser based alignment system. Alternatives like broadband applications increase the chance that over the wavelength range some signal can be detected but this can lead to alignment failure.

In order to alleviate the above mentioned difficulty during imaging of the first layer of colored radiation sensitive material 10 or during imaging of subsequent layer or layers of colored radiation sensitive material, a patterned beam of radiation PB, which is patterned to illuminate only certain areas of the colored radiation sensitive material 10, is patterned to illuminate both areas of a die 40 and areas of a scribe line 50 which are located between dies. Thus, the patterned beam of radiation PB has areas 80 which are patterned for use in forming device features (i.e. filters) in areas of product die 40 as well as areas 90 which are patterned for use in forming features of an alignment mark, particularly in the scribe lines 50.

Figure 7 illustrates a substrate W in plan in which a plurality of dies 40 are illustrated. Each die will form a device at the end of lithographic processing (for example a CCD or CMOS image sensor). Spaces are left between the dies 40 so that the substrate W can be cut along lines 70 in areas known as scribe lines 50. In this way individual devices 40 are produced. As will be apparent, the area of the scribe lines 50 is redundant space which is not used in the device and is only provided to allow for separation of the dies 40 so that the dies can be cut out to form product devices without damaging of the dies. Thus, this space is sometimes used for test structures etc. but there are areas which are presently unused and are therefore "free" for use in the present invention.

Figure 6 illustrates a typical pattern used in an RGB, CMOS or CCD image sensor. Two adjacent dies 40 are illustrated with an alignment mark 101 in the scribe line area 50. The invention applies to other types of pattern, other types of mark as well as to other color types such as cyan, magenta, green and yellow. Therefore, assuming that the first layer of color radiation sensitive material 10 illustrated in Figure 2 is red, it can be assumed that the cross-section is taken through the second row of pixels illustrated in Figure 6 such that square areas of red pixels are illuminated in areas where a red filter is required and features of the alignment mark 101 are also illuminated. This is the case with a negative resist and clearly if a positive resist is used, areas which are required not to have red filters or alignment mark features applied to them are illuminated.

In Figure 2 it can be seen that an area of the first radiation sensitive material 10 is also illuminated with a pattern 90 in the scribe line area 50 of the substrate W. The pattern 90 is for use in forming features of the alignment mark 101 which is to be formed in the scribe line area 50 and defined in the color radiation sensitive resist 10 from the same material and treated in the same way as the material of the filters.

Figure 3 shows the situation following illumination by the projection PB in which areas of the device 40 shown as cross hatching 110 represent areas of colored radiation sensitive material which have been irradiated and the cross hatched area 100 in the scribe line 50 also represents an area which has been irradiated. Assuming the first radiation sensitive material 10 is a negative resist, following development the situation as illustrated in Figure 4 exists in which areas of color filter 110 are left protruding above the second passivation layer 3 and a protruding area 100 of developed radiation sensitive material also exists in the scribe line area 50. Recesses 120 exist between the protrusions 100, 110.

As will be appreciated, if a pattern according to that illustrated in Figure 6 is being developed on the substrate W of Figure 4, the protrusions 110 will be in the form of squares in plan. The protrusion 100 is only schematic, in plan the pattern might look like something similar to the alignment mark 101 in Figure 6. The pattern in the scribe line area is of an alignment mark and may comprise the features for both horizontal and vertical alignment i.e. will have features which are orthogonal to one another for alignment in two dimensions. It may be that features in a scribe line area which extends in the *x* direction are used for alignment in one direction and features in a scribe line area which extends in the *y* direction are used for alignment in the other direction.

Figure 5a shows a first embodiment in which a second radiation sensitive material 20 is applied to the substrate W following development of the first colored radiation sensitive material 110. The second radiation sensitive material 20 is of a different color to the first radiation sensitive material 10. In the embodiment of Figure 5a, a low viscosity second radiation sensitive material is used. In this embodiment the radiation sensitive material flows into the gaps 120 formed between the protrusions 100, 110 of the first radiation sensitive material as is illustrated in Figure 5. The difference in the reflectivity between the imaged alignment feature protrusion 100 of the cured first radiation sensitive material and that of the unexposed and undeveloped second radiation sensitive material 20 provides the "contrast" for the alignment system to detect the alignment mark 100, 101.

A second embodiment is illustrated in Figure 5b in which the second radiation sensitive material is of a relatively high viscosity and it can be seen that in this instance the second radiation sensitive material 20 will build up on the protrusions 100, 110 of the first resist such that the pattern of protrusions of the remaining first radiation sensitive material will be followed by the second layer of radiation sensitive material. In this circumstance the contrast of the alignment mark is provided by the change in step height of the second radiation sensitive material at the position of the protrusion 100 of the first radiation sensitive material.

In this way, it is possible to align the substrate through a colored resist only once (in this case for aligning before exposure of the first colored resist). By choosing the first colored resist to be used carefully (i.e. the one through which conventional alignment marks can most easily be imaged), any difficulties with aligning through colored resist can be minimized. Subsequent alignment will occur on the alignment mark 101 in the resist 10.

The alignment mark 100 will remain during the processing involving all subsequent colored radiation sensitive materials and it is not necessary to add further alignment features during imaging of subsequent colored radiation sensitive materials, though this may be done if desired. Furthermore, the method has been described above in relation to making features in the colored radiation sensitive material 10 which is the first to be applied on the substrate W. However, this is not necessarily the case and the features can be made in other colored radiation sensitive materials further down the processing route. For example, the red radiation sensitive material could be processed in the normal way and the alignment marks only formed in the scribe line areas 50 during imaging of the green colored radiation sensitive material. This is possible because both red and green colored resists do not pose a particular problem for current alignment systems and at the moment it is the blue and cyan colored resists which pose difficulties for the alignment system to image through. However, with future alignment systems different colored resists may pose problems and the order of laying down of the resist and when the alignment marks are first produced in the resist can be chosen accordingly.

The alignment marks in the scribe line area 50 exist after the processing of the substrate has been completed and may exist at the edge of devices once they have been cut from the substrate W. Therefore, it may be possible to tell whether or not a device has been manufactured using the above described method from the device alone.

As will be appreciated, the mask used to pattern both the device 40 and the alignment mark in the scribe line area 50 will be different to previous masks in that previous masks would not have had a patterning structure for endowing the projection beam of radiation with a pattern used for forming an alignment mark in areas outside the dies. Patterning structures for forming alignment marks would previously have been used at lower levels and such masks would not have been suitable for imaging color resists to form color filters of an image sensor.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A device manufacturing method comprising:
- projecting a patterned beam of radiation onto a substrate covered in a first layer of colored radiation sensitive material, the pattern of said patterned beam including a pattern for use in forming device features in areas of product die and a pattern for use in forming features of an alignment mark in other areas.

2. The method of claim 1, further comprising developing said radiation sensitive material such that areas of irradiated first material remain and areas of unirradiated first material are removed or vice versa and applying a second radiation sensitive material wherein said second layer of radiation sensitive material has a different colour to the colour of said first radiation sensitive material.

3. The method of claim 2, wherein said colour of said second radiation sensitive material is blue or cyan.

4. The method of claim 1, 2 or 3, wherein said alignment mark includes substantially orthogonally orientated features for alignment in two orthogonal directions.

5. The method of claim 1, 2, 3 or 4, wherein said alignment mark, after developing and application of a second radiation sensitive material, has a pattern which has contrast due to a step change in height.

6. The method of any one of the preceding claims, wherein said alignment mark, after developing and application of a second radiation sensitive material, has a pattern which has contrast due to changes in reflectively between areas of the mark which are developed first radiation sensitive material and those which are second radiation sensitive material:

7. The method of any one of the preceding claims, wherein the colour of said first radiation sensitive material is green or red or magenta or yellow.

8. The method of any one of the preceding claims, wherein said other areas are in a scribe line area of the substrate.

9. The method of any one of the preceding claims, wherein developed radiation sensitive material forms part of said device.

10. The method of claim any one of the preceding claims, wherein said device is a CMOS or CCD device.

11. The method of any one of the preceding claims, wherein said device features are colour filters.

12. The method of any one of the preceding claims, further comprising aligning said substrate in a lithographic projection apparatus using said features of said alignment mark.

13. A device manufactured according to the method of any one of the preceding claims comprising features of said alignment mark.

14. A mask for use in the method of any one of the preceding claims, comprising patterning structures for endowing a projection beam of radiation with a pattern useful in forming color filters on a die or dies on a substrate and patterning structures for endowing said projection beam of radiation with a pattern useful in forming an alignment mark in areas outside said dies.
